(19)

Europäisches Patentamt
European Patent Office
Office européen des brevets

(11) **EP 4 418 119 A1**

(12) **EUROPEAN PATENT APPLICATION**
published in accordance with Art. 153(4) EPC

(43) Date of publication:
**21.08.2024 Bulletin 2024/34**

(21) Application number: **22880117.1**

(22) Date of filing: **22.09.2022**

(51) International Patent Classification (IPC):
**G06F 9/54** *(2006.01)* **H04L 1/00** *(2006.01)*

(86) International application number:
**PCT/CN2022/120472**

(87) International publication number:
**WO 2023/061177 (20.04.2023 Gazette 2023/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.10.2021 CN 202111190341**

(71) Applicant: **Shenzhen Zhi Hui Lin Network Technology Co., Ltd.**
**Shenzhen, Guangdong 518000 (CN)**

(72) Inventors:
- **KALANTARI, Hamed**
  **Shenzhen, Guangdong 518000 (CN)**
- **MOGHADDAM SARDROUD, Behzad**
  **Shenzhen, Guangdong 518000 (CN)**
- **KALANTARI, Behzad**
  **Shenzhen, Guangdong 518000 (CN)**
- **DING, Xiaoduan**
  **Shenzhen, Guangdong 518000 (CN)**
- **YIN, Yan**
  **Shenzhen, Guangdong 518000 (CN)**
- **HUANG, Kun**
  **Shenzhen, Guangdong 518000 (CN)**

(74) Representative: **Hamer, Christopher K. et al**
**Mathys & Squire**
**The Shard**
**32 London Bridge Street**
**London SE1 9SG (GB)**

(54) **MULTI-DATA SENDING METHOD, APPARATUS AND DEVICE BASED ON COLUMNAR DATA SCANNING, AND MULTI-DATA RECEIVING METHOD, APPARATUS AND DEVICE BASED ON COLUMNAR DATA SCANNING**

(57) A method, device and apparatus for sending multiple data based on columnar data scanning, and a method, device and apparatus for receiving multiple data based on columnar data scanning are provided in the disclosure. The method for sending multiple data includes: obtaining $n$ pieces of data to-be-sent, the $n$ pieces of data to-be-sent being $n$ pieces of data with a same data format, an absolute value of a difference in size between any two of the $n$ pieces of data to-be-sent being less than a first threshold, and $n$ being a positive integer greater than 0; obtaining $n$ first binary data strings by performing binary conversion on each of the $n$ pieces of data to-be-sent, the $n$ first binary data strings being in one-to-one correspondence with the $n$ pieces of data to-be-sent; obtaining a first matrix by stacking the $n$ first binary data strings vertically; obtaining $m$ second binary data strings by splitting the first matrix by columns, $m$ being the number of bits of a binary data string with the maximum number of bits among the $n$ binary data strings, and $m$ being a positive integer greater than 0; and sending the $m$ second binary data strings to a data receiving end.

FIG. 2

- obtain $n$ pieces of data to-be-sent — 201
- obtain $n$ first binary data strings by performing binary conversion on each of the $n$ pieces of data to-be-sent — 202
- obtain a first matrix by stacking the $n$ first binary data strings vertically — 203
- obtain $m$ second binary data strings by splitting the first matrix by columns — 204
- send the $m$ second binary data strings to a data receiving end — 205

Processed by Luminess, 75001 PARIS (FR)

**Description**

CROSS-REFERENCE TO RELATED APPLICATION(S)

This application claims priority to Chinese Patent Application No. 202111190341.6, entitled "METHOD, DEVICE AND APPARATUS FOR SENDING MULTIPLE DATA BASED ON COLUMNAR DATA SCANNING, AND METHOD, DEVICE AND APPARATUS FOR RECEIVING MULTIPLE DATA BASED ON COLUMNAR DATA SCANNING", and filed October 12, 2021, the disclosure of which is hereby incorporated by reference in its entirety.

TECHNICAL FIELD

This application relates to the field of data transmission technology, and particularly to a method, device and apparatus for sending multiple data based on columnar data scanning, and a method, device and apparatus for receiving multiple data based on columnar data scanning.

BACKGROUND

Currently, when transmitting data, in order to obtain higher transmission efficiency, the data is generally compressed or split into multiple sub-data with the same size for transmission. For existing compression technology, data compression generally consumes a large amount of computer resources for massive calculations, but due to the increased bandwidth of modem routers, sending data directly without compression generally takes less time than sending said data subject to compression. For existing data splitting method, data is generally split into multiple sub-data with a same size according to a specific transmission requirement and then the multiple sub-data are sent respectively, and the multiple sub-data are combined at a receiving end. However, in fact, due to problems of the sub-data obtained after splitting such as disk writing and indexing in a disk cluster, data splitting is unable to improve data transmission on the network, but instead leads to a lower data transmission speed on the network. Therefore, the existing data sending method based on compression and splitting fails to increase the data transmission speed on the network, but instead leads to a lower data transmission speed.

SUMMARY

In order to solve the above problems existing in the related art, embodiments of the disclosure provides a method, device and apparatus for sending multiple data based on columnar data scanning, and a method, device and apparatus for receiving multiple data based on columnar data scanning, which can increase a data transmission speed on the network.

In a first aspect, embodiments of the disclosure provide a method for sending multiple data based on columnar data scanning. The method for sending multiple data includes: obtaining $n$ pieces of data to-be-sent, the $n$ pieces of data to-be-sent being $n$ pieces of data with a same data format, an absolute value of a difference in size between any two of the $n$ pieces of data to-be-sent being less than a first threshold, and $n$ being a positive integer greater than 0; obtaining $n$ first binary data strings by performing binary conversion on each of the $n$ pieces of data to-be-sent, the $n$ first binary data strings being in one-to-one correspondence with the $n$ pieces of data to-be-sent; obtaining a first matrix by stacking the $n$ first binary data strings vertically; obtaining $m$ second binary data strings by splitting the first matrix by columns, $m$ being the number of bits of a binary data string with the maximum number of bits among the $n$ binary data strings, and $m$ being a positive integer greater than 0; and sending the $m$ second binary data strings to a data receiving end.

In a second aspect, embodiments of the disclosure provide a method for receiving multiple data based on columnar data scanning. The method for receiving multiple data includes: receiving $x$ third binary data strings from a data sending end, $x$ being an integer greater than or equal to 1; obtaining $x$ vertical data strings by arranging elements in each of the $x$ third binary data strings in order from top to bottom according to arrangement positions of the elements in each of the third binary data strings, the x vertical data strings being in one-to-one correspondence with the $x$ third binary data strings; obtaining a second matrix by concatenating the $x$ vertical data strings horizontally according to an index of each of the third binary data strings; obtaining $y$ fourth binary data strings by splitting the second matrix by rows in order from top to bottom; and obtaining $y$ pieces of original data by performing data restoration on each of the $y$ fourth binary data strings, the $y$ pieces of original data being in one-to-one correspondence with the y binary data strings.

In a third aspect, embodiments of the disclosure provide a device for sending multiple data based on columnar data scanning. The device for sending multiple data includes a first receiving module, a first processing module, and a sending module. The first receiving module is configured to obtain $n$ pieces of data to-be-sent, the $n$ pieces of data to-be-sent being $n$ pieces of data with a same data format, an absolute value of a difference in size between any two of the $n$ pieces of data to-be-sent being less than a first threshold, and $n$ being a positive integer greater than 0. The first processing module is configured to obtain $n$ first binary data strings by performing binary conversion on each of the $n$ pieces of data to-be-sent, the $n$ first binary data strings being in one-to-one correspondence with the $n$ pieces of data to-be-sent; obtain a first matrix by stacking the $n$ first binary data strings vertically; and obtain $m$ second binary data strings by splitting the first matrix by columns, $m$ being the number of bits of a binary data string with the maximum number of bits among the *n* binary data strings, and *m* being a positive integer greater than 0. The sending module is configured to send the *m* second binary data strings to a data receiving end.

In a fourth aspect, embodiments of the disclosure provide a device for receiving multiple data based on columnar data scanning. The device for receiving multiple data includes a second receiving module, a second processing module, and a restoration module. The second receiving module is configured to receive *x* third binary data strings from a data sending end, *x* being an integer greater than or equal to 1. The second processing module is configured to obtain *x* vertical data strings by arranging elements in each of the *x* third binary data strings in order from top to bottom according to arrangement positions of the elements in each of the third binary data strings, the *x* vertical data strings being in one-to-one correspondence with the *x* third binary data strings; obtain a second matrix by concatenating the *x* vertical data strings horizontally according to an index of each of the third binary data strings; and obtain *y* fourth binary data strings by splitting the second matrix by rows in order from top to bottom. The restoration module is configured to obtain *y* pieces of original data by performing data restoration on each of the *y* fourth binary data strings, the *y* pieces of original data being in one-to-one correspondence with the *y* fourth binary data strings.

In a fifth aspect, embodiments of the disclosure provide an apparatus for sending multiple data based on columnar data scanning. The apparatus includes a processor and a memory. The processor is connected with the memory. The memory stores computer programs. The processor is configured to execute the computer programs stored in the memory to cause an electronic device to execute the method of the first aspect.

In a sixth aspect, embodiments of the disclosure provide an apparatus for receiving multiple data based on columnar data scanning. The apparatus includes a processor and a memory. The processor is connected with the memory. The memory stores computer programs. The processor is configured to execute the computer programs stored in the memory to cause an electronic device to execute the method of the second aspect.

In a seventh aspect, embodiments of the disclosure provide a computer-readable storage medium. The computer-readable storage medium stores computer programs which are operable with a computer to execute the method of the first aspect and/or the second aspect.

In an eighth aspect, embodiments of the disclosure provide a computer program product. The computer program product includes a non-transitory computer-readable storage medium storing computer programs. The computer programs are operable with a computer to execute the method of the first aspect and/or the second aspect.

The embodiments of the disclosure have the following advantageous effects.

In the embodiment of the disclosure, the first matrix is obtained by binarizing the *n* pieces of data to-be-sent with the same data format and similar data sizes and then stacking vertically; the *m* second binary data strings are obtained by splitting the first matrix by columns, and finally sent to the data receiving end. Since the *n* pieces of data to-be-sent have the same data format and similar data sizes, after binarized results of the *n* pieces of data to-be-sent are stacked vertically, there will be many redundant bits of the same type in each column, and there will be a column(s) consisting of same elements. In this case, the *m* second binary data strings obtained after splitting by columns are simpler in data structure and more regular, which can effectively improve data processing efficiency when sending, thereby increasing a transmission speed on the network. In addition, since a storage unit, such as a random access memory (RAM), can process bits at the original size during data transmission, data processing is generally completed by a storage unit at the sending end and a storage unit at the receiving end. In the disclosure, the data to-be-sent is converted into binary data, which can realize bit alignment of the data, so that no additional memory is occupied at the sending end and the receiving end, thereby avoiding disk writing and indexing in a disk cluster required by data splitting, and further increasing the transmission speed on the network.

## BRIEF DESCRIPTION OF THE DRAWINGS

In order to describe technical solutions of embodiments of the disclosure more clearly, the following will give a brief description of accompanying drawings used for describing the embodiments. Apparently, accompanying drawings described below are merely some embodiments. Those of ordinary skill in the art can also obtain other accompanying drawings based on the accompanying drawings described below without creative efforts.

FIG. 1 is a schematic diagram illustrating a hardware structure of a device for sending multiple data based on columnar data scanning or a device for receiving multiple data based on columnar data scanning provided in embodiments of the disclosure.

FIG. 2 is a schematic flowchart illustrating a method for sending multiple data based on columnar data scanning provided in embodiments of the disclosure.

FIG. 3 is a schematic flowchart illustrating details of obtaining *m* simplified data strings by performing multiple character-scanning-processes on each of *m* second binary data strings provided in embodiments of the disclosure.

FIG. 4 is a schematic flowchart illustrating details of sending a target data string to a data receiving end provided in embodiments of the disclosure.

FIG. 5 is a schematic flowchart illustrating a method for receiving multiple data based on columnar data scanning provided in embodiments of the disclosure.
FIG. 6 is a block diagram illustrating functional modules of a device for sending multiple data based on columnar data scanning provided in embodiments of the disclosure.
FIG. 7 is a block diagram illustrating functional modules of a device for receiving multiple data based on columnar data scanning provided in embodiments of the disclosure.
FIG. 8 is a schematic structural diagram illustrating an apparatus for sending multiple data based on columnar data scanning provided in embodiments of the disclosure.
FIG. 9 is a schematic structural diagram illustrating an apparatus for receiving multiple data based on columnar data scanning provided in embodiments of the disclosure.

DETAILED DESCRIPTION

Hereinafter, technical solutions of embodiments of the disclosure will be described clearly and completely with reference to accompanying drawings in the embodiments. Apparently, embodiments described below are merely some embodiments, rather than all embodiments of the disclosure. All other embodiments obtained by those of ordinary skill in the art based on the embodiments described below without creative efforts shall fall within the protection scope of the disclosure.

The terms "first", "second", "third", "fourth", and the like used in the specification, the claims, and the accompany drawings of the disclosure are used to distinguish different objects rather than describe a particular order. In addition, the terms "include", "comprise", and "have" as well as variations thereof are intended to cover non-exclusive inclusion. For example, a process, method, system, product, or device including a series of steps or units is not limited to the listed steps or units, on the contrary, it can optionally include other steps or units that are not listed; alternatively, other steps or units inherent to the process, method, product, or device can be included either.

The term "embodiment" referred to herein means that particular features, structures, or properties described in conjunction with the embodiments may be defined in at least one embodiment of the disclosure. The phrase "embodiment" appearing in various places in the specification does not necessarily refer to the same embodiment or an independent/ alternative embodiment that is mutually exclusive with other embodiments. Those skilled in the art will understand expressly and implicitly that an embodiment described herein may be combined with other embodiments.

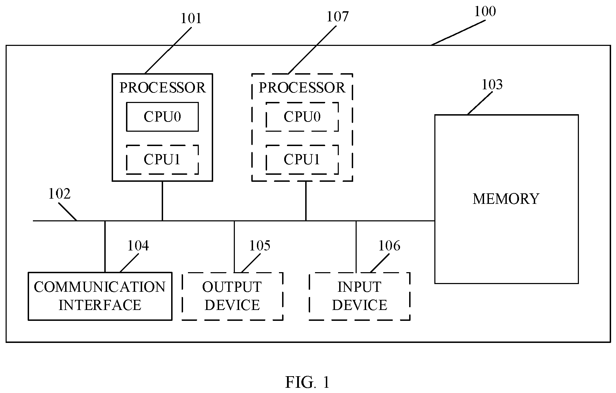

Referring to FIG. 1, FIG. 1 is a schematic diagram illustrating a hardware structure of a device for sending multiple data based on columnar data scanning or a device for receiving multiple data based on columnar data scanning provided in embodiments of the disclosure. The device for sending multiple data or the device for receiving multiple data includes at least one processor 101, a communication line 102, a memory 103, and at least one communication interface 104.

In these embodiments, the processor 101 may be a central processing unit (CPU), a microprocessor, an application-specific integrated circuit (ASIC), or one or more integrated circuits for controlling execution of programs corresponding to solutions of the disclosure.

The communication line 102 may include a path for information transmission among the above-mentioned components.

The communication interface 104 may be any transceiver device (e.g., an antenna), and is configured to communicate with other devices or communication networks, such as the Ethernet, the radio access network (RAN), the wireless local area network (WLAN), etc.

The memory 103 may be, but is not limited to, a read-only memory (ROM) or other types of static storage devices that can store static information and instructions, a random access memory (RAM) or other types of dynamic storage devices that can store information and instructions, and may also be an electrically erasable programmable ROM (EEPROM), a compact disc ROM (CD-ROM) or other compact disc storage, optical disc storage (including compact disc, laser disc, optical disc, digital versatile disc, Blu-ray disc, etc.), a magnetic disk storage medium or other magnetic storage devices, or any other medium capable of carrying or storing desired program codes in the form of instructions or data structures and capable of being accessed by a computer.

In these embodiments, the memory 103 may exist independently and be connected with the processor 101 through the communication line 102. The memory 103 may also be integrated with the processor 101. The memory 103 of embodiments of the disclosure is generally non-volatile. The memory 103 is used to store computer execution instructions for executing solutions of the disclosure, and is controlled by the processor 101 for execution. The processor 101 is configured to execute the computer execution instructions stored in the memory 103, to implement the method of the following embodiments of the disclosure.

In an optional embodiment, the computer execution instructions can also be called application codes, which are not limited in the disclosure.

In an optional embodiment, the processor 101 may include one or more CPUs. For example, in FIG. 1, the processor 101 includes CPU0 and CPU1.

In an optional embodiment, the device for sending multiple data based on columnar data scanning or the device for receiving multiple data based on columnar data scanning may also include multiple processors. For example, in FIG. 1, the device includes a processor 101 and a processor 107. Each of these processors may be a single-CPU processor or a multi-CPU processor. The processor herein may refer to one or more devices, circuits, and/or processing cores for processing data (e.g.,

computer program instructions).

In an optional embodiment, the device for sending multiple data based on columnar data scanning or the device for receiving multiple data based on columnar data scanning is a server. In this case, the device may also include an output device 105 and an input device 106. The output device 105 communicates with the processor 101 and can display information in a variety of ways. For example, the output device 105 may be a liquid crystal display (LCD), a light-emitting diode (LED) display device, a cathode ray tube (CRT) display device, or a projector, etc. The input device 106 communicates with processor 101 and can receive user input in a variety of ways. For example, the input device 106 may be a mouse, a keyboard, a touch screen device, or a sensing device, etc.

The device for sending multiple data based on columnar data scanning and the device for receiving multiple data based on columnar data scanning each may be a general-purpose device or a special-purpose device, and the type of the device is not limited in embodiments of the disclosure.

A method for sending multiple data based on columnar data scanning disclosed in the disclosure will be depicted below.

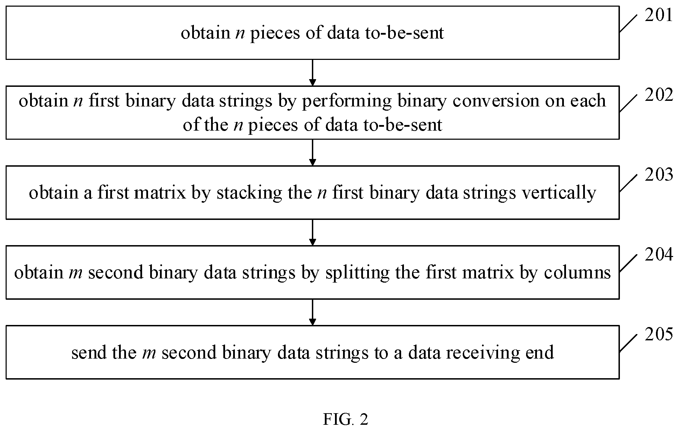

Referring to FIG. 2, FIG. 2 is a schematic flowchart illustrating a method for sending multiple data based on columnar data scanning provided in embodiments of the disclosure. The method for sending multiple data based on columnar data scanning includes the following.

201, obtain $n$ pieces of data to-be-sent.

In these embodiments, the $n$ pieces of data to-be-sent are $n$ pieces of data with the same data format, and an absolute value of a difference in size between any two of the $n$ pieces of data to-be-sent is less than a first threshold, and $n$ is a positive integer greater than 0. As an example, the $n$ pieces of data to-be-sent are $n$ pieces of data with the same data format and similar size in the same set of DICOM files.

202, obtain $n$ first binary data strings by performing binary conversion on each of the $n$ pieces of data to-be-sent.

In these embodiments, the $n$ first binary data strings are in one-to-one correspondence with the $n$ pieces of data to-be-sent.

203, obtain a first matrix by stacking the $n$ first binary data strings vertically.

In these embodiments, the method for sending multiple data based on columnar data scanning provided in the disclosure will be described in combination with an exemplary situation where $n$ is equal to 3. For instance, there are three pieces of DCM data that meet a requirement of the operations at 201: DCM1, DCM2, and DCM3. After binarizing the three pieces of DCM data respectively, three first binary data strings are obtained as below:

$$DCM1 => 11010011;$$

$$DCM2 => 11010011;$$

$$DCM3 => 10011011;$$

after stacking the three first binary data strings vertically, a first matrix is obtained as below:

$$\begin{bmatrix} 1 & 1 & 0 & 1 & 0 & 0 & 1 & 1 \\ 1 & 1 & 0 & 1 & 0 & 0 & 1 & 1 \\ 1 & 0 & 0 & 1 & 1 & 0 & 1 & 1 \end{bmatrix}$$

204, obtain $m$ second binary data strings by splitting the first matrix by columns.

In these embodiments, $m$ is the number of bits of a binary data string with the maximum number of bits among the $n$ binary data strings, and $m$ is a positive integer greater than 0. Exemplarily, following the above example where $n$ is equal to 3, the maximum number of bits among the three first binary data strings is 8. Therefore, after splitting the first matrix by columns, 8 second binary data strings are obtained as follows: [111, 110, 000, 111, 001, 000, 111, 111].

205, send the $m$ second binary data strings to a data receiving end.

In these embodiments, since the $n$ pieces of data to-be-sent have the same data format and similar sizes, the $n$ first binary data strings obtained after binarization of the $n$ pieces of data to-be-sent are also relatively similar. There will be many redundant bits of the same type in each of the $m$ second binary data strings obtained by splitting by column after stacking the $n$ first binary data strings vertically, and there will also be a second binary data string(s) composed of same elements, such as 111 or 000. As such, the $m$ second binary data strings obtained have simpler data structure and strong regularity. Therefore, converting the $n$ pieces of data to-be-sent into the $m$ second binary data strings for sending can effectively improve data processing efficiency, thereby increasing a transmission speed on the network.

In optional embodiments, in view of existence of many redundant bits of the same type in each of the second binary data strings and existence of a second binary data string(s) composed of same elements, each of the second binary data strings is simplified to further increase a transmission speed on the network. As an example, after the $m$ second binary data strings are obtained, $m$ simplified data strings are obtained by performing multiple character-scanning-processes on each of the $m$ second binary data strings. A target data string is obtained by concatenating the $m$ simplified data strings vertically according to an arrangement position of each of the second binary data strings in the first matrix. The target data string is sent to the data receiving end.

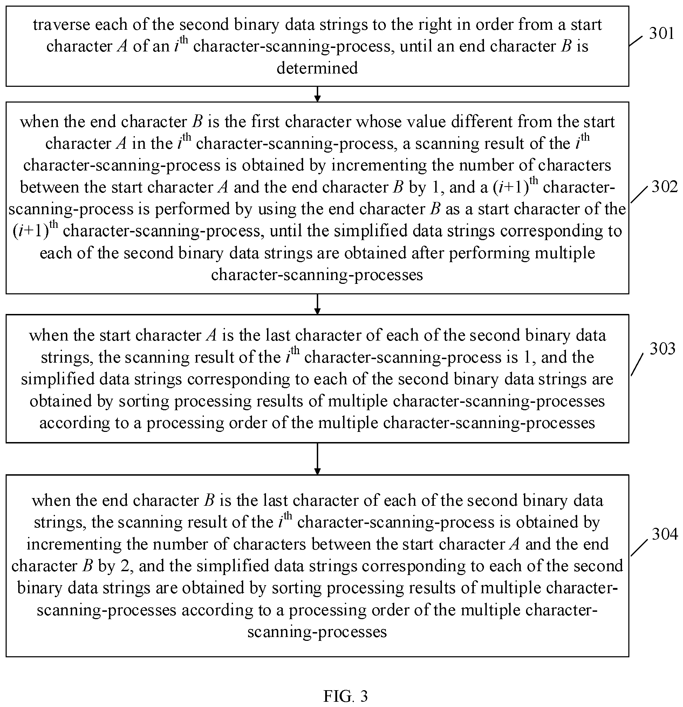

Specifically, in some embodiments, as illustrated in FIG. 3, details of obtaining the $m$ simplified data strings by performing multiple character-scanning-processes on each of the $m$ second binary data strings are as follows.

301, traverse each of the second binary data strings to the right in order from a start character $A$ of an $i^{th}$ character-scanning-process, until an end character $B$ is determined.

In these embodiments, the end character $B$ is a first character whose value different from the start character $A$ in the $i^{th}$ character-scanning-process, or the end character $B$ is a last character of each of the second binary data strings. $i$ is an integer greater than or equal to 1. When $i=1$, the start character A is a first character of each of the second binary data strings.

302, when the end character $B$ is the first character whose value different from the start character $A$ in the $i^{th}$ character-scanning-process, a scanning result of the $i^{th}$ character-scanning-process is obtained by incrementing the number of characters between the start character $A$ and the end character $B$ by 1, and a $(i+1)^{th}$ character-scanning-process is performed by using the end character $B$ as a start character of the $(i+1)^{th}$ character-scanning-process, until the simplified data strings corresponding to each of the second binary data strings are obtained after performing multiple character-scanning-processes.

303, when the start character $A$ is the last character of each of the second binary data strings, the scanning result of the $i^{th}$ character-scanning-process is 1, and the simplified data strings corresponding to each of the second binary data strings are obtained by sorting processing results of multiple character-scanning-processes according to a processing order of the multiple character-scanning-processes.

304, when the end character $B$ is the last character of each of the second binary data strings, the scanning result of the $i^{th}$ character-scanning-process is obtained by incrementing the number of characters between the start character $A$ and the end character $B$ by 2, and the simplified data strings corresponding to each of the second binary data strings are obtained by sorting processing results of multiple character-scanning-processes according to a processing order of the multiple character-scanning-processes.

Exemplarily, following the above example where $n$ is equal to 3, the 8 second binary data strings obtained are [111, 110, 000, 111, 001, 000, 111, 111]. For the 1st second binary data string "111", a start character A of the 1st character-scanning-process is the first character "1". Traverse to the right in order to the last character, but no first character different from the start character $A$ appears. In this case, the third character "1" is used as an end character $B$, and a simplified data string corresponding to the 1st second binary data string "111" is recorded as "3" (incrementing the number of characters between the first character and the third character by 2, that is, 1+2).

For the 2nd second binary data string " 110", a start character $A$ of the 1st character-scanning-process is the first character "1". Traverse to the right in order, and the (obtained) first character different from the start character $A$ is the third character "0". In this case, the third character is used as an end character $B$ of the 1st character-scanning-process, and a scanning result of the 1st character-scanning-process is recorded as "2" (incrementing the number of characters between the first character and the third character by 1, that is, 1+1). Then, a start character $A$ of the 2nd character-scanning-process is the end character $B$ of the 1st character-scanning-process, that is, the third character "0". Because the third character is the last character, a scanning result of the 2nd character-scanning-process is recorded as "1". In this case, the scanning result of the 1 st character-scanning-process and the scanning result of the 2nd character-scanning-process are sorted according to a processing order of multiple character-scanning-processes, and a simplified data string corresponding to the 2nd second binary data string "110" can be obtained as "21".

In such way, the 8 second binary data strings can be simplified in order to obtain 8 simplified data strings [3, 21, 3, 3, 21, 3, 3, 3]. Then, the 8 simplified data strings are concatenated vertically to obtain a target data string "3213321333".

It can be seen that, when $n$ takes a value of hundreds or even thousands, that is, when sending hundreds or thousands of pieces of data that meet a requirement at the same time, said data can be compressed greatly through the above-mentioned splitting transformation, without complex compression calculations, which can greatly reduces consumption of computing resources and compression time. Moreover, corresponding data contents cannot be directly restored from each compressed fragment, thereby improving data security.

In optional embodiments, every 256 pieces of data are set as a group for transmission. When a second binary data string composed of same elements (i.e., a second binary data string composed of all 0s or 1s) appears, a simplified result of said second binary data string is 256, and this simplified result only occupies 1 byte on the network, which greatly reduces a bandwidth requirement of the network and further increases a transmission speed on the network.

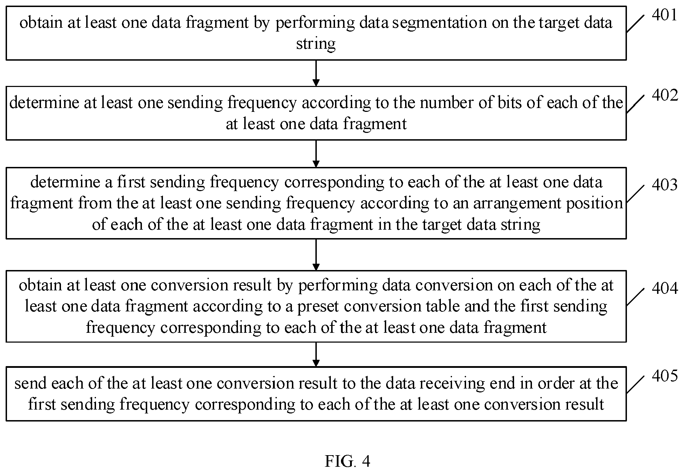

In addition, in some embodiments, as illustrated in FIG. 4, details of sending the target data string to the data receiving end are as follows.

401, obtain at least one data fragment by performing data segmentation on the target data string.

In these embodiments, a segmentation bit number $k$ (i.e., the quantity of bits of data after splitting) is determined, and then the target data string is split into at least one data fragment with same number of bits according to the segmentation bit number $k$. As an example, *k* is any integer greater than 1. In these embodiments, the details of sending the target data string to the data receiving end provided in the disclosure will be described in combination with an exemplary situation where *k* is equal to 2.

Specifically, when *k* is equal to 2, it means that the segmentation bit number is set to 2. In this case, data segmentation is performed so that every 2 bits of the target data string are classified as one group. Following the above example where the target data string is "3213321333", the target data string can be split into [32, 13, 32, 13, 33] when the segmentation bit number is 2.

In optional embodiments, the segmentation bit number may also be a dynamic and cyclic value. For instance, the segmentation bit number is a segmentation sequence [*m*, *x*, *y*]. When performing data segmentation on binary data, perform *m*-bit segmentation, perform *x*-bit segmentation, perform *y*-bit segmentation, perform *m*-bit segmentation, and so on, until segmentation of the binary data is completed. Specifically, if the segmentation sequence is [1, 2, 3] and the target data string is "321332133312", a segmentation result can be obtained as [3, 21, 332, 1, 33, 312].

402, determine at least one sending frequency according to the number of bits of each of the at least one data fragment.

In these embodiments, the number of required sending frequencies (i.e., first quantity) is first determined based on the number of bits of each of the at least one data fragment. As an example, the first quantity is the same as the number of bits of each of the at least one data fragment, that is, the first quantity is equal to *k*. The first quantity and the number of bits of each of the at least one data fragment may also satisfy other functional relationships. In a possible embodiment, the relationship between the first quantity I and the number *k* of bits of each of the at least one data fragment can be expressed by formula ①:

$$l=2^{k}........①$$

In these embodiments, data sending based on multiple frequencies provided in the disclosure will be described in combination with an exemplary situation where the first quantity is equal to *k*. Following the above example where *k* is equal to 2, it can be determined that the first quantity is also 2. Therefore, 2 sending frequencies can be randomly selected from a preset sending-frequency library as the at least one sending frequency.

403, determine a first sending frequency corresponding to each of the at least one data fragment from the at least one sending frequency according to an arrangement position of each of the at least one data fragment in the target data string.

In these embodiments, the at least one sending frequency obtained at 402 can be sorted randomly, and according to an arrangement position of each of the at least one data fragment in the target data string, one sending frequency can be selected from the sorted at least one sending frequency sequentially as the sending frequency corresponding to each data fragment.

Specifically, following the above example where *k* is equal to 2, in this example, 2 sending frequencies (i.e., sending frequency *A* and sending frequency *B*) are selected, and a sequence [sending frequency *A*, sending frequency *B*] is obtained after sorting the 2 sending frequencies. A data-fragment sequence corresponding to the target data string "3213321333" is [32, 13, 32, 13, 33]. Based on this, it is determined that the 1st data fragment "32" corresponds to sending frequency *A*, the 2nd data fragment "13" corresponds to sending frequency *B*, the 3rd data fragment "32" corresponds to sending frequency *A*, the 4th data fragment "13" corresponds to sending frequency *B*, and the 5th data fragment "33" corresponds to sending frequency *A*.

404, obtain at least one conversion result by performing data conversion on each of the at least one data fragment according to a preset conversion table and the first sending frequency corresponding to each of the at least one data fragment.

In these embodiments, the conversion table records conversion results corresponding to different data fragments at different sending frequencies, and the at least one conversion result is in one-to-one correspondence with the at least one data fragment.

405, send each of the at least one conversion result to the data receiving end in order at the first sending frequency corresponding to each of the at least one conversion result.

In optional embodiments, the *m* second binary data strings are not simplified, and the *m* second binary data strings are concatenated vertically according to an arrangement position of each of the second binary data strings in the first matrix to directly obtain the target data string. The target data string is sent to the data receiving end through the operations at 401-405.

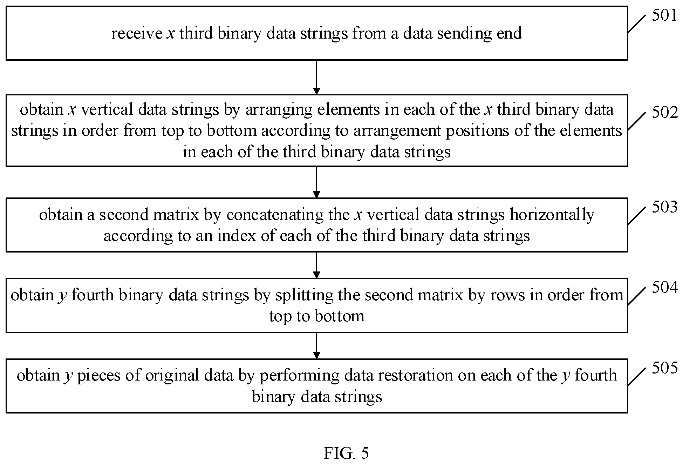

Further, referring to FIG. 5, FIG. 5 is a schematic flowchart illustrating a method for receiving multiple data based on columnar data scanning provided in embodiments of the disclosure. The method for receiving multiple data based on columnar data scanning includes the following.

501, receive *x* third binary data strings from a data sending end.

In these embodiments, *x* is an integer greater than or equal to 1.

502, obtain x vertical data strings by arranging elements in each of the x third binary data strings in order from top to bottom according to arrangement positions of the elements in each of the third binary data strings.

In these embodiments, the *x* vertical data strings are in one-to-one correspondence with the x third binary data strings.

503, obtain a second matrix by concatenating the *x* vertical data strings horizontally according to an index of each of the third binary data strings.

504, obtain *y* fourth binary data strings by splitting the second matrix by rows in order from top to bottom.

505, obtain *y* pieces of original data by performing data restoration on each of they fourth binary data strings.

In these embodiments, they pieces of original data are in one-to-one correspondence with the *y* binary data strings.

In sum, in the method for sending multiple data based on columnar data scanning of the disclosure, the first matrix is obtained by binarizing the *n* pieces of data to-be-sent with the same data format and similar data sizes and then stacking vertically; the *m* second binary data strings are obtained by splitting the first matrix by columns, and finally sent to the data receiving end. Since the *n* pieces of data to-be-sent have the same data format and similar data sizes, after binarized results of the *n* pieces of data to-be-sent are stacked vertically, there will be many redundant bits of the same type in each column, and there will be a column(s) consisting of same elements. In this case, the *m* second binary data strings obtained after splitting by columns are simpler in data structure and more regular, which can effectively improve data processing efficiency when sending, thereby increasing a transmission speed on the network. In addition, since a storage unit, such as a RAM, can process bits at the original size during data transmission, data processing is generally completed by a storage unit at the sending end and a storage unit at the receiving end. In the disclosure, the data to-be-sent is converted into binary data, which can realize bit alignment of the data, so that no additional memory is occupied at the sending end and the receiving end, thereby avoiding disk writing and indexing in a disk cluster required by data splitting, and further increasing the transmission speed on the network.

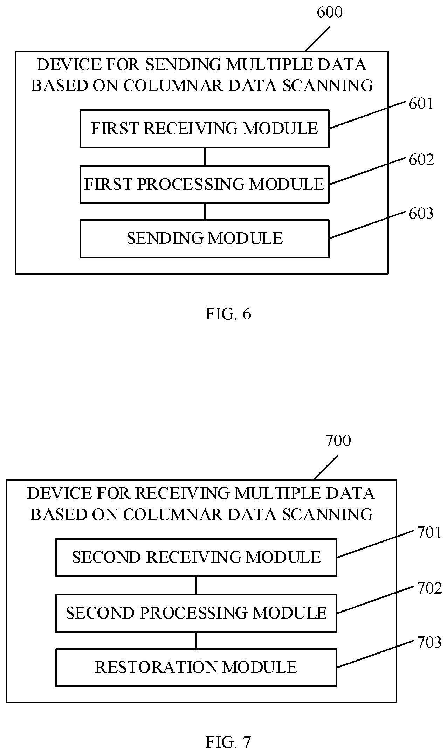

Referring to FIG. 6, FIG. 6 is a block diagram illustrating functional modules of a device for sending multiple data based on columnar data scanning provided in embodiments of the disclosure. As illustrated in FIG. 6, a device 600 for sending multiple data based on columnar data scanning includes a first receiving module 601, a first processing module 602, and a sending module 603. The first receiving module 601 is configured to obtain *n* pieces of data to-be-sent, where the *n* pieces of data to-be-sent are *n* pieces of data with a same data format, an absolute value of a difference in size between any two of the *n* pieces of data to-be-sent is less than a first threshold, and *n* is a positive integer greater than 0. The first processing module 602 is configured to obtain *n* first binary data strings by performing binary conversion on each of the *n* pieces of data to-be-sent, where the *n* first binary data strings are in one-to-one correspondence with the *n* pieces of data to-be-sent; obtain a first matrix by stacking the *n* first binary data strings vertically; and obtain *m* second binary data strings by splitting the first matrix by columns, where *m* is the number of bits of a binary data string with the maximum number of bits among the *n* binary data strings, and *m* is a positive integer greater than 0. The sending module 603 is configured to send the *m* second binary data strings to a data receiving end.

In embodiments of the disclosure, after obtaining the *m* second binary data strings by splitting the first matrix by columns, the first processing module 602 is further configured to: obtain *m* simplified data strings by performing multiple character-scanning-processes on each of the *m* second binary data strings, where the *m* simplified data strings obtained are in one-to-one correspondence with the *m* second binary data strings; and obtain a target data string by concatenating the *m* simplified data strings vertically according to an arrangement position of each of the second binary data strings in the first matrix. The sending module 603 configured to send the *m* second binary data strings to the data receiving end is configured to send the target data string to the data receiving end.

In embodiments of the disclosure, the first processing module 602 configured to obtain the *m* simplified data strings by performing multiple character-scanning-processes on each of the *m* second binary data strings is specifically configured to: traverse each of the second binary data strings to the right in order from a start character *A* of an $i^{th}$ character-scanning-process, until an end character *B* is determined, where the end character *B* is a first character whose value different from the start character A in the $i^{th}$ character-scanning-process or is a last character of each of the second binary data strings, and i is an integer greater than or equal to 1; the start character A is a first character of each of the second binary data strings when *i*=1; when the end character *B* is the first character whose value different from the start character A in the $i^{th}$ character-scanning-process, a scanning result of the $i^{th}$ character-scanning-process being obtained by incrementing the number of characters between the start character *A* and the end character *B* by 1, and perform a $(i+1)^{th}$ character-scanning-process by using the end character *B* as a start character of the $(i+1)^{th}$ character-scanning-process, until the simplified data strings corresponding to each of the second binary data strings are obtained after performing multiple character-scanning-processes; when the start character *A* is the last character of each of the second binary data strings, the scanning result of the $i^{th}$ character-scanning-process being 1, and obtain the simplified data strings corresponding to each of the second binary data strings by sorting processing results of multiple character-scanning-processes according to a processing order of the multiple character-scanning-processes; and when the end character *B* is the last character of each of the second binary data strings, the scanning result of the $i^{th}$ character-scanning-process being obtained by incrementing the number of characters between the start character *A* and the end character *B* by 2, and obtain the simplified data strings corresponding to each of the second binary data strings by sorting processing results of multiple character-scanning-processes according to a processing order of the multiple character-scanning-processes.

In embodiments of the disclosure, the sending module 603 configured to send the target data string to the data receiving end is specifically configured to: obtain at least one data fragment by performing data segmentation on the target data string; determine at least one sending frequency according to the number of bits of each of the at least one data fragment; determine a first sending frequency corresponding to each of the at least one data fragment from the at least one sending frequency according to an arrangement position of each of the at least one data fragment in the target data string; obtain at least one conversion result by performing data conversion on each of the at least one data fragment according to a preset conversion table and the first sending frequency corresponding to each of the at least one data fragment, where the conversion table records conversion results corresponding to different data fragments at different sending frequencies, and the at least one conversion result is in one-to-one correspondence with the at least one data fragment; and send each of the at least one conversion result to the data receiving end in order at the first sending frequency corresponding to each of the at least one conversion result.

Also, referring to FIG. 7, FIG. 7 is a block diagram illustrating functional modules of a device for receiving multiple data based on columnar data scanning provided in embodiments of the disclosure. As illustrated in FIG. 7, a device 700 for receiving multiple data based on columnar data scanning includes a second receiving module 701, a second processing module 702, and a restoration module 703. The second receiving module 701 is configured to receive x third binary data strings from a data sending end, where x is an integer greater than or equal to 1. The second processing module 702 is configured to obtain x vertical data strings by arranging elements in each of the x third binary data strings in order from top to bottom according to arrangement positions of the elements in each of the third binary data strings, where the x vertical data strings are in one-to-one correspondence with the x third binary data strings; obtain a second matrix by concatenating the x vertical data strings horizontally according to an index of each of the third binary data strings; and obtain y fourth binary data strings by splitting the second matrix by rows in order from top to bottom. The restoration module 703 is configured to obtain y pieces of original data by performing data restoration on each of they fourth binary data strings, where the y pieces of original data are in one-to-one correspondence with the y binary data strings.

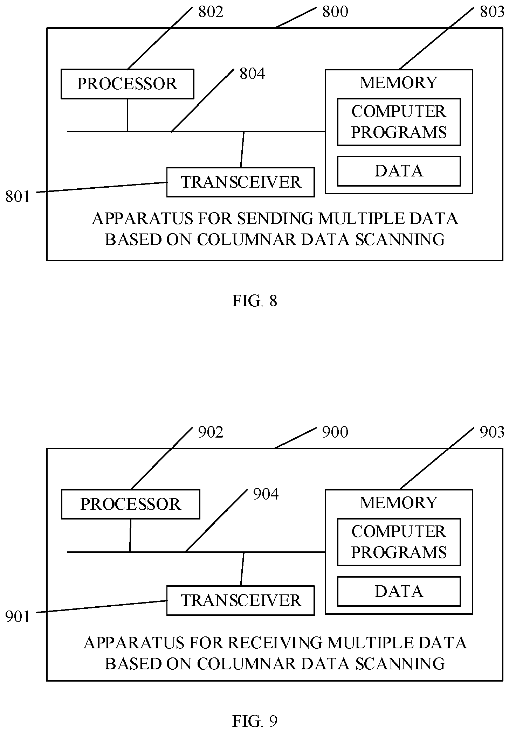

Referring to FIG. 8, FIG. 8 is a schematic structural diagram illustrating an apparatus for sending multiple data based on columnar data scanning provided in embodiments of the disclosure. As illustrated in FIG. 8, an apparatus 800 for sending multiple data based on columnar data scanning includes a transceiver 801, a processor 802, and a memory 803. The transceiver 801, the processor 802, and the memory 803 are connected to each other through a bus 804. The memory 803 is used to store computer programs and data, and the data stored in the memory 803 can be transmitted to the processor 802.

The processor 802 is configured to read the computer programs in the memory 803 to: obtain $n$ pieces of data to-be-sent, where the $n$ pieces of data to-be-sent are $n$ pieces of data with a same data format, an absolute value of a difference in size between any two of the $n$ pieces of data to-be-sent is less than a first threshold, and $n$ is a positive integer greater than 0; obtain $n$ first binary data strings by performing binary conversion on each of the $n$ pieces of data to-be-sent, where the $n$ first binary data strings are in one-to-one correspondence with the $n$ pieces of data to-be-sent; obtain a first matrix by stacking the $n$ first binary data strings vertically; obtain $m$ second binary data strings by splitting the first matrix by columns, where $m$ is the number of bits of a binary data string with the maximum number of bits among the $n$ binary data strings, and $m$ is a positive integer greater than 0; and send the $m$ second binary data strings to a data receiving end.

In embodiments of the disclosure, after obtaining the $m$ second binary data strings by splitting the first matrix by columns, the processor 802 is further configured to: obtain $m$ simplified data strings by performing multiple character-scanning-processes on each of the $m$ second binary data strings, where the $m$ simplified data strings obtained are in one-to-one correspondence with the $m$ second binary data strings; and obtain a target data string by concatenating the $m$ simplified data strings vertically according to an arrangement position of each of the second binary data strings in the first matrix. The processor 802 configured to send the $m$ second binary data strings to the data receiving end is configured to send the target data string to the data receiving end.

In embodiments of the disclosure, the processor 802 configured to obtain the $m$ simplified data strings by performing multiple character-scanning-processes on each of the $m$ second binary data strings is specifically configured to: traverse each of the second binary data strings to the right in order from a start character $A$ of an $i^{th}$ character-scanning-process, until an end character $B$ is determined, where the end character $B$ is a first character whose value different from the start character $A$ in the $i^{th}$ character-scanning-process or is a last character of each of the second binary data strings, and $i$ is an integer greater than or equal to 1; the start character $A$ is a first character of each of the second binary data strings when $i$=1; when the end character $B$ is the first character whose value different from the start character $A$ in the $i^{th}$ character-scanning-process, a scanning result of the $i^{th}$ character-scanning-process being obtained by incrementing the number of characters between the start character $A$ and the end character $B$ by 1, and perform a $(i+1)^{th}$ character-scanning-process by using the end character *B* as a start character of the $(i+1)^{th}$ character-scanning-process, until the simplified data strings corresponding to each of the second binary data strings are obtained after performing multiple character-scanning-processes; when the start *character A* is the last character of each of the second binary data strings, the scanning result of the $i^{th}$ character-scanning-process being 1, and obtain the simplified data strings corresponding to each of the second binary data strings by sorting processing results of multiple character-scanning-processes according to a processing order of the multiple character-scanning-processes; and when the end character *B* is the last character of each of the second binary data strings, the scanning result of the $i^{th}$ character-scanning-process being obtained by incrementing the number of characters between the start character A and the end character *B* by 2, and obtain the simplified data strings corresponding to each of the second binary data strings by sorting processing results of multiple character-scanning-processes according to a processing order of the multiple character-scanning-processes.

In embodiments of the disclosure, the processor 802 configured to send the target data string to the data receiving end is specifically configured to: obtain at least one data fragment by performing data segmentation on the target data string; determine at least one sending frequency according to the number of bits of each of the at least one data fragment; determine a first sending frequency corresponding to each of the at least one data fragment from the at least one sending frequency according to an arrangement position of each of the at least one data fragment in the target data string; obtain at least one conversion result by performing data conversion on each of the at least one data fragment according to a preset conversion table and the first sending frequency corresponding to each of the at least one data fragment, where the conversion table records conversion results corresponding to different data fragments at different sending frequencies, and the at least one conversion result is in one-to-one correspondence with the at least one data fragment; and send each of the at least one conversion result to the data receiving end in order at the first sending frequency corresponding to each of the at least one conversion result.

Also, referring to FIG. 9, FIG. 9 is a schematic structural diagram illustrating an apparatus for receiving multiple data based on columnar data scanning provided in embodiments of the disclosure. As illustrated in FIG. 9, an apparatus 900 for receiving multiple data based on columnar data scanning includes a transceiver 901, a processor 902, and a memory 903. The transceiver 901, the processor 902, and the memory 903 are connected to each other through a bus 904. The memory 903 is used to store computer programs and data, and the data stored in the memory 903 can be transmitted to the processor 902.

The processor 902 is configured to read the computer programs in the memory 903 to: receive *x* third binary data strings from a data sending end, where *x* is an integer greater than or equal to 1; obtain *x* vertical data strings by arranging elements in each of the *x* third binary data strings in order from top to bottom according to arrangement positions of the elements in each of the third binary data strings, where the x vertical data strings are in one-to-one correspondence with the *x* third binary data strings; obtain a second matrix by concatenating the *x* vertical data strings horizontally according to an index of each of the third binary data strings; obtain *y* fourth binary data strings by splitting the second matrix by rows in order from top to bottom; and obtain *y* pieces of original data by performing data restoration on each of the *y* fourth binary data strings, where they pieces of original data are in one-to-one correspondence with *they* binary data strings.

It should be understood that, the device for sending multiple data based on columnar data scanning and the device for receiving multiple data based on columnar data scanning of the disclosure each may include a smart phone (e.g., an Android® phone, an iOS® phone, a Windows® Phone), a tablet computer, a handheld computer, a laptop computer, a mobile Internet device (MID), a robot, a wearable device, etc. The above only gives some examples of the device for sending multiple data based on columnar data scanning and the device for receiving multiple data based on columnar data scanning, and is not exhaustive. The device for sending multiple data based on columnar data scanning and the device for receiving multiple data based on columnar data scanning each include, but not limited to, the examples listed above. In practice, the device for sending multiple data based on columnar data scanning and the device for receiving multiple data based on columnar data scanning each may also include an intelligent vehicle-mounted terminal, computer equipment, etc.

Through the description of the above embodiments, those skilled in the art can clearly understand that the disclosure can be implemented by means of software combined with a hardware platform. Based on such understanding, all or part of the technical solutions of the disclosure that contributes to the existing art can be embodied in the form of a software product. The (computer) software product can be stored in a storage medium (e.g., a ROM/RAM, a disk, or a CD), and includes instructions which are operable with a computer device (e.g., a personal computer, a server, or a network device) to execute the method described in the various embodiments of the disclosure or certain parts of the embodiments of the disclosure.

Embodiments of the disclosure further provide a computer-readable storage medium. The computer-readable storage medium stores computer programs which, when executed by a processor, are operable to execute all or part of the operations of the method for sending multiple data based on columnar data scanning and the method for receiving multiple data based on columnar data scanning described in the foregoing method embodiments. For instance, the storage medium may include a hard disk, a floppy disk, an optical disk, a magnetic tape, a magnetic disk, a universal serial bus (USB), a flash memory, etc.

Embodiments of the disclosure further provide a computer program product. The computer program product includes a non-transitory computer-readable storage medium storing computer programs. The computer programs are operable with a computer to execute all or part of the operations of the method for sending multiple data based on columnar data scanning and the method for receiving multiple data based on columnar data scanning described in the foregoing method embodiments.

It is to be noted that, for the sake of simplicity, the foregoing method embodiments are described as a series of action combinations, however, it will be appreciated by those skilled in the art that the disclosure is not limited by the sequence of actions described. That is because that, according to the disclosure, certain steps or operations may be performed in other order or simultaneously. Besides, it will be appreciated by those skilled in the art that the embodiments described in the specification are exemplary embodiments and the actions and modules involved are not necessarily essential to the disclosure.

In the foregoing embodiments, the description of each embodiment has its own emphasis. For the parts not described in detail in one embodiment, reference may be made to related descriptions in other embodiments.

In the embodiments of the disclosure, it should be understood that, the device/ apparatus disclosed in embodiments provided herein may be implemented in other manners. For example, the device embodiments described above are merely illustrative; for instance, the division of the unit is only a logical function division and there can be other manners of division during actual embodiments, for example, multiple units or assemblies may be combined or may be integrated into another system, or some features may be ignored, omitted, or not performed. In addition, coupling or communication connection between each illustrated or discussed component may be direct coupling or communication connection, or may be indirect coupling or communication among devices or units via some interfaces, and may be electrical connection or other forms of connection.

The units described as separate components may or may not be physically separated, the components illustrated as units may or may not be physical units, that is, they may be in the same place or may be distributed to multiple network elements. Part or all of the units may be selected according to actual needs to achieve the purpose of the technical solutions of the embodiments.

In addition, the functional units in various embodiments of the disclosure may be integrated into one processing unit, or each unit may be physically present, or two or more units may be integrated into one unit. The above-mentioned integrated unit can be implemented in the form of hardware or a software function unit.

The integrated unit may be stored in a computer-readable memory when it is implemented in the form of a software functional unit and is sold or used as a separate product. Based on such understanding, the technical solutions of the disclosure essentially, or the part of the technical solutions that contributes to the related art, or all or part of the technical solutions, may be embodied in the form of a software product which is stored in a memory and includes instructions for causing a computer device (which may be a personal computer, a server, or a network device and so on) to perform all or part of the operations described in the various embodiments of the disclosure. The memory includes various medium capable of storing program codes, such as a USB, a ROM, a RAM, a removable hard disk, a disk, a CD, or the like.

It will be understood by those of ordinary skill in the art that all or a part of the various methods of the embodiments described above may be accomplished by means of a program to instruct associated hardware, the program may be stored in a computer-readable memory, which may include a flash memory, a ROM, a RAM, a disk or CD, etc.

While the principles and the embodiments of the disclosure have been depicted in detail in combination with illustrative examples, it is to be understood that foregoing embodiments are merely used to help understand the method and the core idea of the disclosure. As will occur to those skilled in the art, the disclosure is susceptible to various modifications and changes without departing from the spirit of the disclosure. Therefore, the contents of the specification should not be understood as a limitation on the disclosure.

**Claims**

1. A method for sending multiple data based on columnar data scanning, applied to a data sending end and comprising:

obtaining $n$ pieces of data to-be-sent, the $n$ pieces of data to-be-sent being $n$ pieces of data with a same data format, an absolute value of a difference in size between any two of the $n$ pieces of data to-be-sent being less than a first threshold, and $n$ being a positive integer greater than 0;
obtaining $n$ first binary data strings by performing binary conversion on each of the $n$ pieces of data to-be-sent, the $n$ first binary data strings being in one-to-one correspondence with the $n$ pieces of data to-be-sent;
obtaining a first matrix by stacking the $n$ first binary data strings vertically;
obtaining $m$ second binary data strings by splitting the first matrix by columns, $m$ being the number of bits of a binary data string with the maximum number of bits among the *n* binary data strings, and *m* being a positive integer greater than 0; and

sending the *m* second binary data strings to a data receiving end.

2. The method of claim 1, wherein

after obtaining the *m* second binary data strings by splitting the first matrix by columns, the method further comprises:

obtaining *m* simplified data strings by performing multiple character-scanning-processes on each of the *m* second binary data strings, wherein the *m* simplified data strings obtained are in one-to-one correspondence with the *m* second binary data strings; and

obtaining a target data string by concatenating the *m* simplified data strings vertically according to an arrangement position of each of the second binary data strings in the first matrix; and

sending the *m* second binary data strings to the data receiving end comprises:
sending the target data string to the data receiving end.

3. The method of claim 2, wherein obtaining the *m* simplified data strings by performing multiple character-scanning-processes on each of the *m* second binary data strings comprises:

traversing each of the second binary data strings to the right in order from a start character *A* of an $i^{th}$ character-scanning-process, until an end character *B* is determined, wherein the end character *B* is a first character whose value different from the start character *A* in the $i^{th}$ character-scanning-process or is a last character of each of the second binary data strings, and *i* is an integer greater than or equal to 1; the start character *A* is a first character of each of the second binary data strings when *i*=1;
when the end character *B* is the first character whose value different from the start character *A* in the $i^{th}$ character-scanning-process, a scanning result of the $i^{th}$ character-scanning-process being obtained by incrementing the number of characters between the start *character A* and the end character *B* by 1, and performing a $(i+1)^{th}$ character-scanning-process by using the end character *B* as a start character of the $(i+1)^{th}$ character-scanning-process, until the simplified data strings corresponding to each of the second binary data strings are obtained after performing multiple character-scanning-processes;
when the start character *A* is the last character of each of the second binary data strings, the scanning result of the $i^{th}$ character-scanning-process being 1, and obtaining the simplified data strings corresponding to each of the second binary data strings by sorting processing results of multiple character-scanning-processes according to a processing order of the multiple character-scanning-processes; and
when the end character *B* is the last character of each of the second binary data strings, the scanning result of the $i^{th}$ character-scanning-process being obtained by incrementing the number of characters between the start character *A* and the end character *B* by 2, and obtaining the simplified data strings corresponding to each of the second binary data strings by sorting processing results of multiple character-scanning-processes according to a processing order of the multiple character-scanning-processes.

4. The method of claim 2 or 3, wherein sending the target data string to the data receiving end comprises:

obtaining at least one data fragment by performing data segmentation on the target data string;
determining at least one sending frequency according to the number of bits of each of the at least one data fragment;
determining a first sending frequency corresponding to each of the at least one data fragment from the at least one sending frequency according to an arrangement position of each of the at least one data fragment in the target data string;
obtaining at least one conversion result by performing data conversion on each of the at least one data fragment according to a preset conversion table and the first sending frequency corresponding to each of the at least one data fragment, wherein the conversion table records conversion results corresponding to different data fragments at different sending frequencies, and the at least one conversion result is in one-to-one correspondence with the at least one data fragment; and
sending each of the at least one conversion result to the data receiving end in order at the first sending frequency corresponding to each of the at least one conversion result.

5. A method for receiving multiple data based on columnar data scanning, applied to a data receiving end and comprising:

receiving *x* third binary data strings from a data sending end, *x* being an integer greater than or equal to 1;

obtaining *x* vertical data strings by arranging elements in each of the *x* third binary data strings in order from top to bottom according to arrangement positions of the elements in each of the third binary data strings, the x vertical data strings being in one-to-one correspondence with the x third binary data strings;

obtaining a second matrix by concatenating the *x* vertical data strings horizontally according to an index of each of the third binary data strings;

obtaining *y* fourth binary data strings by splitting the second matrix by rows in order from top to bottom; and

obtaining *y* pieces of original data by performing data restoration on each of the *y* fourth binary data strings, *they* pieces of original data being in one-to-one correspondence with the *y* binary data strings.

6. A device for sending multiple data based on columnar data scanning, comprising:

a first receiving module, configured to obtain *n* pieces of data to-be-sent, the *n* pieces of data to-be-sent being *n* pieces of data with a same data format, an absolute value of a difference in size between any two of the *n* pieces of data to-be-sent being less than a first threshold, and *n* being a positive integer greater than 0;

a first processing module, configured to obtain *n* first binary data strings by performing binary conversion on each of the *n* pieces of data to-be-sent, the *n* first binary data strings being in one-to-one correspondence with the *n* pieces of data to-be-sent; obtain a first matrix by stacking the *n* first binary data strings vertically; and obtain *m* second binary data strings by splitting the first matrix by columns, *m* being the number of bits of a binary data string with the maximum number of bits among the *n* binary data strings, and *m* being a positive integer greater than 0; and

a sending module, configured to send the *m* second binary data strings to a data receiving end.

7. A device for receiving multiple data based on columnar data scanning, comprising:

a second receiving module, configured to receive x third binary data strings from a data sending end, *x* being an integer greater than or equal to 1;

a second processing module, configured to obtain *x* vertical data strings by arranging elements in each of the *x* third binary data strings in order from top to bottom according to arrangement positions of the elements in each of the third binary data strings, the *x* vertical data strings being in one-to-one correspondence with the *x* third binary data strings; obtain a second matrix by concatenating the *x* vertical data strings horizontally according to an index of each of the third binary data strings; and obtain *y* fourth binary data strings by splitting the second matrix by rows in order from top to bottom; and

a restoration module, configured to obtain y pieces of original data by performing data restoration on each of *they* fourth binary data strings, the *y* pieces of original data being in one-to-one correspondence with *they* fourth binary data strings.

8. An apparatus for sending multiple data based on columnar data scanning, comprising:

a processor;
a memory;
a communication interface; and
one or more programs, stored in the memory and configured to be executed by the processor; the one or more programs comprising instructions which are operable to execute the operations of the method of any of claims 1 to 4.

9. An apparatus for receiving multiple data based on columnar data scanning, comprising:

a processor;
a memory;
a communication interface; and
one or more programs, stored in the memory and configured to be executed by the processor; the one or more programs comprising instructions which are operable to execute the operations of the method of claim 5.

10. A computer-readable storage medium, storing computer programs which, when executed by a processor, are operable to implement the method of any of claims 1 to 5.

101    107    100

PROCESSOR    PROCESSOR    103

CPU0    CPU0    MEMORY

CPU1    CPU1

102

104    105    106

COMMUNICATION
INTERFACE    OUTPUT
DEVICE    INPUT
DEVICE

FIG. 1

obtain *n* pieces of data to-be-sent / 201

obtain *n* first binary data strings by performing binary conversion on each of the *n* pieces of data to-be-sent / 202

obtain a first matrix by stacking the *n* first binary data strings vertically / 203

obtain *m* second binary data strings by splitting the first matrix by columns / 204

send the *m* second binary data strings to a data receiving end / 205

FIG. 2

traverse each of the second binary data strings to the right in order from a start character $A$ of an $i^{th}$ character-scanning-process, until an end character $B$ is determined $\qquad$ 301

when the end character $B$ is the first character whose value different from the start character $A$ in the $i^{th}$ character-scanning-process, a scanning result of the $i^{th}$ character-scanning-process is obtained by incrementing the number of characters between the start character $A$ and the end character $B$ by 1, and a $(i+1)^{th}$ character-scanning-process is performed by using the end character $B$ as a start character of the $(i+1)^{th}$ character-scanning-process, until the simplified data strings corresponding to each of the second binary data strings are obtained after performing multiple character-scanning-processes $\qquad$ 302

when the start character $A$ is the last character of each of the second binary data strings, the scanning result of the $i^{th}$ character-scanning-process is 1, and the simplified data strings corresponding to each of the second binary data strings are obtained by sorting processing results of multiple character-scanning-processes according to a processing order of the multiple character-scanning-processes $\qquad$ 303

when the end character $B$ is the last character of each of the second binary data strings, the scanning result of the $i^{th}$ character-scanning-process is obtained by incrementing the number of characters between the start character $A$ and the end character $B$ by 2, and the simplified data strings corresponding to each of the second binary data strings are obtained by sorting processing results of multiple character-scanning-processes according to a processing order of the multiple character-scanning-processes $\qquad$ 304

FIG. 3

obtain at least one data fragment by performing data segmentation on the target data string  / 401

determine at least one sending frequency according to the number of bits of each of the at least one data fragment  / 402

determine a first sending frequency corresponding to each of the at least one data fragment from the at least one sending frequency according to an arrangement position of each of the at least one data fragment in the target data string  / 403

obtain at least one conversion result by performing data conversion on each of the at least one data fragment according to a preset conversion table and the first sending frequency corresponding to each of the at least one data fragment  / 404

send each of the at least one conversion result to the data receiving end in order at the first sending frequency corresponding to each of the at least one conversion result  / 405

FIG. 4

```
┌────────────────────────────────────────────────────────────────────┐
│          receive x third binary data strings from a data sending end  │──╱ 501
└────────────────────────────────────────────────────────────────────┘
                                    │
                                    ▼
┌────────────────────────────────────────────────────────────────────┐
│  obtain x vertical data strings by arranging elements in each of the x third binary data │──╱ 502
│  strings in order from top to bottom according to arrangement positions of the elements  │
│                    in each of the third binary data strings          │
└────────────────────────────────────────────────────────────────────┘
                                    │
                                    ▼
┌────────────────────────────────────────────────────────────────────┐
│  obtain a second matrix by concatenating the x vertical data strings horizontally  │──╱ 503
│              according to an index of each of the third binary data strings  │
└────────────────────────────────────────────────────────────────────┘
                                    │
                                    ▼
┌────────────────────────────────────────────────────────────────────┐
│  obtain y fourth binary data strings by splitting the second matrix by rows in order from  │──╱ 504
│                                top to bottom           │
└────────────────────────────────────────────────────────────────────┘
                                    │
                                    ▼
┌────────────────────────────────────────────────────────────────────┐
│  obtain y pieces of original data by performing data restoration on each of the y fourth  │──╱ 505
│                            binary data strings         │
└────────────────────────────────────────────────────────────────────┘
```

FIG. 5

600

DEVICE FOR SENDING MULTIPLE DATA
BASED ON COLUMNAR DATA SCANNING

FIRST RECEIVING MODULE — 601

FIRST PROCESSING MODULE — 602

SENDING MODULE — 603

FIG. 6

700

DEVICE FOR RECEIVING MULTIPLE DATA
BASED ON COLUMNAR DATA SCANNING

SECOND RECEIVING MODULE — 701

SECOND PROCESSING MODULE — 702

RESTORATION MODULE — 703

FIG. 7

802    800    803

PROCESSOR

804

MEMORY

COMPUTER
PROGRAMS

DATA

TRANSCEIVER

801

APPARATUS FOR SENDING MULTIPLE DATA
BASED ON COLUMNAR DATA SCANNING

FIG. 8

902    900    903

PROCESSOR

904

MEMORY

COMPUTER
PROGRAMS

DATA

TRANSCEIVER

901

APPARATUS FOR RECEIVING MULTIPLE DATA
BASED ON COLUMNAR DATA SCANNING

FIG. 9

## INTERNATIONAL SEARCH REPORT

| International application No. |
| --- |
| **PCT/CN2022/120472** |

**A. CLASSIFICATION OF SUBJECT MATTER**

G06F 9/54(2006.01)i;  H04L 1/00(2006.01)i

According to International Patent Classification (IPC) or to both national classification and IPC

**B. FIELDS SEARCHED**

Minimum documentation searched (classification system followed by classification symbols)

G06F; H04L

Documentation searched other than minimum documentation to the extent that such documents are included in the fields searched

Electronic data base consulted during the international search (name of data base and, where practicable, search terms used)

CNPAT, CNKI, BAIDU, EPODOC, WPI, IEEE: 数据, 扫描, 矩阵, 压缩, 规律, 接近, 阈值, 差, 还原, 列, 发送, 接收, 二进制, 串, 竖向, 堆叠, 拆分, 纵向, 拼接, 位置, 横向, data, scan, matrix, compression, regular, proximity, threshold, difference, restore, column, transmit, receive, binary, serial, vertical, stack, split, stitch, position, lateral

**C. DOCUMENTS CONSIDERED TO BE RELEVANT**

| Category* | Citation of document, with indication, where appropriate, of the relevant passages | Relevant to claim No. |
| --- | --- | --- |
| PX | CN 114064308 A (SHENZHEN ZHIHUILIN NETWORK TECHNOLOGY CO., LTD.) 18 February 2022 (2022-02-18)<br>claims 1-10 | 1-10 |
| A | CN 112737728 A (HUAWEI TECHNOLOGIES CO., LTD.) 30 April 2021 (2021-04-30)<br>description, paragraphs [0076]-[0256], and figures 1-10 | 1-10 |
| A | CN 109525372 A (SHENZHEN CHINA STAR OPTOELECTRONICS TECHNOLOGY CO., LTD.) 26 March 2019 (2019-03-26)<br>entire document | 1-10 |
| A | CN 111769837 A (HUANG TAO) 13 October 2020 (2020-10-13)<br>entire document | 1-10 |
| A | CN 106452451 A (HUNAN QIANNIAN HUAGUANG SOFTWARE DEVELOPMENT CO., LTD.) 22 February 2017 (2017-02-22)<br>entire document | 1-10 |
| A | US 2017221153 A1 (MASTERCARD INTERNATIONAL INC.) 03 August 2017 (2017-08-03)<br>entire document | 1-10 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **10 December 2022** | **15 December 2022** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/120472**

| Patent document cited in search report | | | Publication date (day/month/year) | Patent family member(s) | | | Publication date (day/month/year) |
|---|---|---|---|---|---|---|---|
| CN | 114064308 | A | 18 February 2022 | None | | | |
| CN | 112737728 | A | 30 April 2021 | None | | | |
| CN | 109525372 | A | 26 March 2019 | WO | 2020133797 | A1 | 02 July 2020 |
| CN | 111769837 | A | 13 October 2020 | None | | | |
| CN | 106452451 | A | 22 February 2017 | None | | | |
| US | 2017221153 | A1 | 03 August 2017 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111190341